(19) **Europäisches Patentamt**
**European Patent Office**
**Office européen des brevets**

(11) **EP 3 381 059 B1**

(12) **EUROPEAN PATENT SPECIFICATION**

(45) Date of publication and mention
of the grant of the patent:
**28.07.2021  Bulletin 2021/30**

(51) Int Cl.:
***H01L 31/055*** *(2014.01)*

(21) Application number: **16801990.9**

(86) International application number:
**PCT/EP2016/077850**

(22) Date of filing: **16.11.2016**

(87) International publication number:
**WO 2017/089196 (01.06.2017 Gazette 2017/22)**

(54) **PHOTOVOLTAIC DEVICE**

FOTOVOLTAIKVORRICHTUNG

DISPOSITIF PHOTOVOLTAÏQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **25.11.2015  EP 15196313**

(43) Date of publication of application:
**03.10.2018  Bulletin 2018/40**

(73) Proprietor: **AGC Glass Europe
1348 Louvain-La-Neuve (BE)**

(72) Inventors:
• **LAMBRICHT, Thomas
  1360 Perwez (BE)**
• **POOT, Benoît
  7830 Thoricourt (BE)**
• **DOMERCQ, Benoît
  1420 Braine-l'Alleud (BE)**

(74) Representative: **AGC Glass Europe
Technovation Centre
Intellectual Property Department
Rue Louis Blériot 12
6041 Gosselies (BE)**

(56) References cited:
**WO-A1-2009/011188      WO-A1-2014/180679
US-A1- 2010 139 769      US-A1- 2013 087 193**

## Description

### 1. Field of the invention

The present invention generally relates to a device capable of converting incident radiation, especially solar radiation, into electricity by means of solar (or photovoltaic) cells, and more particularly to a device of this type that collects and concentrates more effectively the incident radiation for use by these cells. In particular, the invention relates to a photovoltaic (PV) device including one or more photovoltaic cells and an assembly of at least one glass sheet that is transparent to the incident radiation, and of a matrix in which are dispersed luminescent elements capable of absorbing the incident radiation and of re-emitting it with a longer wavelength, so that the wavelength of the new radiation falls in the zone of sensitivity of the one or more photovoltaic cells, the area of which is much smaller than that of each major face (generating area <<< collecting area).

Such a device is essentially, but not only, applicable to the harvesting of solar energy in the architectural field (device of the "building-integrated photovoltaics" or "BIPV" type).

### 2. Solutions of the prior art

Devices for concentrating radiation have been known about for a very long time and, for example, some have already been described in patents EP0004242B1, DE2628291 and US4127425.

In addition, in the article by E. WEBER and J. LAMBE published in "Applied Optics" volume 15, no. 10 pages 2299-2300, a radiation collector placed in an enclosure the upper surface of which is a window made of glass or of plastic and the lower surface of which is a mirror is described.

Patent EP0004242B describes a concentrator of solar radiation in which the radiation ($\lambda$1) passes through a matrix in which are distributed substances operating in luminescent cascade and capable of absorbing energy in a range of wavelengths ($\lambda$1) and of re-emitting it in a range of longer wavelengths ($\lambda$2), the latter range corresponding to the zone of optimal sensitivity of a solar photovoltaic cell at which said radiation arrives and the useful energy of which is thus amplified, wherein said matrix is located in an enclosure at least one portion of which, via which said radiation penetrates before passing through said matrix, is formed of a substance having a first refractive index (n1) on the side of the exterior of the enclosure, and a second refractive index (n2) on the side of said matrix, said second index being as high as possible with respect to said first index, the rest of said enclosure being opaque to said radiation arriving at the photovoltaic cells also located in the enclosure.

Patent DE2628291 describes a device for converting solar energy into electrical power, wherein the incident light is captured in a transparent or "concentrator" layer of higher refractive index than that of the surrounding medium and containing "fluorescent centres"; the light re-emitted is then directed towards conventional solar cells.

Patent US4127425 describes a device for collecting radiation made up of a luminescent planar layer and a solar cell placed on one of the lateral faces, the layer is formed by a matrix in which one or more luminescent agents are distributed. The other lateral faces and the lower face may be covered with mirrors. Radiation incident on the upper face is absorbed and re-emitted in an angle of $4\pi$. By successive internal reflections, an intense flux of light of the desired wavelength is then channelled towards the end covered by the cell. The luminescent planar layers may be formed of glass or of a polymer in which luminescent agents are dispersed. These agents may directly emit light the energy of which is in the vicinity of the range to which the solar cell is sensitive; they may also emit this light by means of a cascade mechanism. In addition, in the device of US4727425, the one or more photovoltaic cells are positioned on an edge face of the luminescent layer that has been enlarged so as to increase the area of said edge face and to allow cells of larger area to be used and thus an increased generating area to be obtained.

US2013/0087193 is directed to the technical field of see-through solar cells modules and their structure and discloses a solar cell unit including a fluorescent converging plate including (i) a light guide plate for guiding light therein to an end surface thereof and (ii) fluorescent materials which absorb first invisible light which enters the light guide plate and then emit second invisible light differing in wavelength from the first invisible light; and a solar cell provided on an end surface of the fluorescent covering plate so as to have a light receiving surface which faces the end surface. US2010/139769 is directed to solar concentrators which include light turning structure to alter the patch of light radiant on an optical waveguide to improve the performance of the solar concentrator.

In all the devices of the prior art, the absorption of the incident radiation and/or the re-emission of the new radiation occur(s) at least in part in the visible domain thus giving the device a colour in transmission and/or absorption that is not often desirable in architectural applications. In addition, these known devices have only a very modest area (of about 100 cm$^2$) and/or a very low to moderate efficiency and/or are relatively unstable over time (especially because of the use of organic luminophores) and/or are not sufficiently transparent in the visible.

In order to make all these known devices actually envisageable in architectural applications, it is vital to significantly increase their size, typically to about 1 m by 2 m, or even 2 m by 4 m (or even more). Such dimensions then generate, if known devices are considered, a significant loss in the energy of the re-emitted radiation by absorption in the material of the device and thus the output of the device is extremely decreased.

If glass is considered to be the transparent material of choice in such devices and if the glazed area is to be increased enough to achieve a size that is large enough for architectural applications in particular, it is clear that this effect of absorption of the re-emitted radiation is critical.

In addition, in order to avoid the visible domain for the aforementioned reasons, it would be advantageous for the absorbed and/or re-emitted radiation to be located in the UV or near-infrared domain. In the case of a conversion towards longer wavelengths, it would be judicious to use the near-infrared domain for the re-emitted radiation. Thus, if the conventional soda-lime glass called "clear" glass is considered as the transparent material in such devices, the latter has a coefficient of absorption of 30 $m^{-1}$ at the wavelength 850 nm. The consequence of such a coefficient of absorption is that after only 2.3 cm of travel through the glass, 50% of the re-emitted radiation has already been reabsorbed and, after only 15.4 cm of travel through the glass, there remains less than 1% of the initially re-emitted radiation. What is called "extra clear" soda-lime glass, having a low iron content, has, for its part, a coefficient of absorption of 4 $m^{-1}$ at the wavelength 850 nm. The consequence of such a coefficient of absorption is that after only 17cm of travel through the glass, 50% of the re-emitted radiation has already been reabsorbed and, after 115 cm of travel through the glass, there remains less than 1% of the initially re-emitted radiation.

One of the ways to solve this major problem would be to increase the generating area (therefore the number and/or size of the photovoltaic cells). In conventional PV devices, increasing the generating area automatically leads to a drastic increase in the total cost of the device and, potentially, requires the major faces of the matrix to be occupied (due to a lack of space on the edge faces thereof) thereby, necessarily, then unbearably impacting the general appearance of the PV device, which at least partially loses its transparency (as is the case with conventional BIPV devices including opaque zones corresponding to solar cells placed on their major faces). The device of patent US4727425 attempts to get around this drawback by specifically and locally increasing the thickness of the edge face of the luminescent matrix and thus allowing the area of the solar cells to be increased but (i) the negative impact on cost is still present with respect to the preceding solution and (ii) the local increase in the thickness of an edge face cannot be achieved easily with each and every type of substrate/matrix (and certainly not in the case of a transparent matrix made of glass).

There is therefore a need to provide the photovoltaic market with a glazing unit for BIPV applications that is efficient, transparent in the visible and large in size. Another market need is to provide a functional glazing unit (for architectural or automotive applications) that is transparent in the visible and that is "autonomous", i.e. able to produce all the power/electricity that it requires to operate. One example of such a functional glazing unit is a window incorporating a detector/sensor or an electrochromic layer.

### 3. Objectives of the invention

The objective of the invention, in at least one of its embodiments, is to provide a photovoltaic device allowing the drawbacks of the PV devices of the prior art to be remedied.

In particular, the objective of the invention, in at least one of its embodiments, is to provide a photovoltaic device allowing the loss of re-emitted radiation by absorption to be very greatly decreased.

The objective of the invention, in at least one of its embodiments, is also to provide a photovoltaic device using re-emitted radiation that is invisible to the eye.

Another objective of the invention, in at least one of its embodiments, is to provide a photovoltaic device that allows the transparency of said device to be maintained when it is seen from its major faces.

Finally, another objective of the invention is to provide a concentrating photovoltaic device that is inexpensive to produce.

### 4. Summary of the invention

The invention relates to a photovoltaic device intended to convert into electricity incident radiation $\Phi 1$ of a wavelength $\lambda 1$ comprised between 280 and 1000 nm, comprising:

(i) an assembly having two external major faces f1 and f3, comprising

- a glass sheet V1 having two major faces f1 and f2, the face f1 being that via which the incident radiation $\Phi 1$ penetrates into the assembly and said sheet V1 being transparent to said incident radiation $\Phi 1$;

- a functional layer F covering the major face f2 of the sheet V1 and comprising a matrix in which are dispersed luminescent elements capable of absorbing said incident radiation $\Phi 1$ of wavelength $\lambda 1$ and of re-emitting it with a wavelength $\lambda 2$ longer than $\lambda 1$ and comprised between 800 and 1400 nm;

which assembly plays the role of waveguide for the radiation re-emitted of wavelength $\lambda 2$, and

(ii) at least one photovoltaic cell (C1, C2, C3, ...) positioned (i) on one or more edge faces of the assembly, and/or (ii) on the major face f1, and/or (iii) on the major face f3, and at which the re-emitted radiation of wavelength $\lambda 2$ arrives and which is sensitive to the wavelength $\lambda 2$;

in which device the glass sheet V1 has a coefficient of absorption at the wavelength $\lambda 2$ lower than 3 m$^{-1}$ and has a composition that comprises, in a content expressed in percentage by total weight of glass:

| | |
|---|---|
| Total iron expressed in the form of $Fe_2O_3$ | 0.002 - 0.06%; |
| $Cr_2O_3$ | 0.0001 - 0.06%. |

Thus, the invention is based on a completely novel and inventive approach. The inventors have indeed demonstrated that it is possible to obtain a very efficient PV device allowing, if desired, the transparency required for architectural applications to be achieved, and preserving its efficiency even when its dimensions are very large (about a plurality of metres), by combining, in an assembly, a glass sheet associated with a functional layer including luminescent elements capable of absorbing incident radiation of wavelength $\lambda 1$ and of re-emitting it with a wavelength $\lambda 2$ longer than $\lambda 1$ and located between 800 and 1400 nm; the glass sheet being highly transmissive at the wavelength $\lambda 2$.

In the invention, this particular glass sheet-functional layer assembly plays the role of a very effective waveguide for the radiation re-emitted isotropically by the luminescent elements, so as to gain a maximum of benefit from this new radiation and to harvest therefrom a maximum of energy usable by the photovoltaic cells. Thus, certain advantages are achieved: firstly, the photovoltaic cells may, at equal power, be decreased in number/area since the output of the device is improved with respect to the PV devices of the prior art, thereby allowing the cost of the device to be decreased and/or enough space to be found on the edge face of the assembly for the cells to be positioned thereon, thereby then allowing a "transparent" device usable as an architectural glazing unit to be obtained

Throughout the present text, when a range is indicated, the end values are included. In addition, all the integer values and sub-ranges in a numerical range are expressly included as if explicitly written. Also throughout the present text, the content values are in percentages, unless explicitly specified otherwise (for example, in ppm). Similarly, also throughout the present text, all the content values in percentages are by weight, i.e. expressed relative to the total weight of the glass.

Other features and advantages of the invention will become more clearly apparent on reading the following description, examples and figures, in which:

- Figure 1 shows a schematic of the device according to the invention;

- Figure 2 is a variant embodiment of the device in Figure 1;

- Figure 3 is a variant embodiment of the device in Figure 1;

- Figure 4 is a variant embodiment of the device in Figure 2;

- Figure 5 is a variant embodiment of the device in Figure 3;

- Figure 6 is a variant embodiment of the device in Figure 1;

- Figure 7 is a variant embodiment of the device in Figure 1; and

- Figure 8 is a variant embodiment of the device in Figure 2.

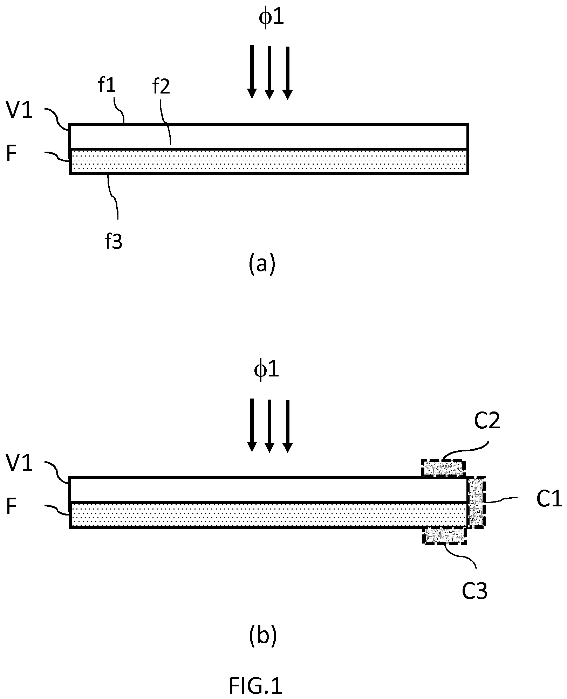

The assembly according to the invention, illustrated in Figure 1(a), comprises:

- a glass sheet V1 having two major faces f1 and f2, the face f1 being that via which the incident radiation penetrates into the assembly and said sheet V1 being transparent to said incident radiation $\Phi 1$; and

- a functional layer F covering the face f2 of the sheet V1 and comprising a matrix in which are dispersed luminescent elements (LE) capable of absorbing said incident radiation $\Phi 1$ of wavelength $\lambda 1$ and of re-emitting it with a wavelength $\lambda 2$ longer than $\lambda 1$ and comprised between 800 and 1400 nm.

The assembly according to the invention illustrated in Figure 1 comprises two external major faces f1 and f3 and secondary faces corresponding to the edge faces of the assembly and that have a significantly smaller area than the area of said major faces f1 and f3.

The glass sheet V1 according to the invention is transparent to the incident radiation $\Phi 1$ of wavelength $\lambda 1$. By transparent to the incident radiation $\Phi 1$, what is meant according to the invention is that the glass sheet has a transmittance at the wavelength $\lambda 1$ higher than 10%.

The glass sheet V1 may be a glass sheet obtained by a float process, a drawing process, or a rolling process or any other known process for manufacturing a glass sheet from a molten glass composition. Preferably, the glass sheet V1 is a float glass sheet. The glass sheet V1 may have a thickness varying between 0.1 and 25 mm. Advantageously the glass sheet V1 according to the invention may have a thickness between 4 and 12 mm. The glass sheet V1 according to the invention is made of glass possibly belonging to various categories in terms of base composition. The glass can thus be a glass of soda-lime-silica, aluminosilicate or borosilicate type, and the like. Preferably, the base composition of the glass sheet V1 comprises, in a content expressed in percentage by total weight of glass:

| | |
|---|---|
| $SiO_2$ | 55 - 85% |
| $Al_2O_3$ | 0 - 30% |
| $B_2O_3$ | 0 - 20% |
| $Na_2O$ | 0 - 25% |
| CaO | 0 - 20% |
| MgO | 0 - 15% |
| $K_2O$ | 0 - 20% |
| BaO | 0 - 20%. |

More preferably, the base composition of the glass sheet V1 comprises, in a content expressed in percentage by total weight of glass:

| | |
|---|---|
| $SiO_2$ | 55 - 78% |
| $Al_2O_3$ | 0 - 18% |
| $B_2O_3$ | 0 - 18% |
| $Na_2O$ | 0 - 20% |
| CaO | 0 - 15% |
| MgO | 0 - 10% |
| $K_2O$ | 0 - 10% |
| BaO | 0 - 5%. |

Most preferably and for reasons of lower production costs, the glass sheet V1 according to the invention is a sheet of soda-lime-silica glass. Advantageously, according to this embodiment, the base composition of the glass sheet V1 comprises, in a content expressed in percentage by total weight of glass:

| | |
|---|---|
| $SiO_2$ | 60 - 75% |
| $Al_2O_3$ | 0 - 6% |
| $B_2O_3$ | 0 - 4% |
| CaO | 0 - 15% |
| MgO | 0 - 10% |
| $Na_2O$ | 5 - 20% |
| $K_2O$ | 0 - 10% |
| BaO | 0 - 5%. |

In addition to its base composition, the glass sheet V1 may comprise other components, of nature and quantity tailored to the sought-after effect.

According to the invention the glass sheet V1 advantageously has a very low coefficient of absorption at the wavelength $\lambda 2$, which is comprised between 800 and 1400 nm, compared to usual glasses (such as what is called "clear" or even "extra clear" glass).

To quantify the good transmittance of the glass in the infrared domain at the specific wavelengths of interest for the applications in question, in the present description the coefficient of absorption at the wavelength of interest, i.e. at the wavelength of re-emission of the luminescent elements (in particular, in the near-infrared wavelength range extending from 800 to 1400 nm) will be used. The coefficient of absorption is defined by the ratio of the absorbance to the length of the optical path travelled by electromagnetic radiation in a given medium. It is expressed in $m^{-1}$. It is thus independent of the thickness of the material but it is a function of the wavelength of the radiation absorbed and of the chemical nature of the material.

In the case of glass, the coefficient of absorption ($\mu$) at a chosen wavelength $\lambda$ may be calculated from a measurement of transmittance (T) and from the refractive index n of the material (*thick* = thickness), the values of n, $\rho$ and T depending on the chosen wavelength $\lambda$:

$$\mu = -\frac{1}{thick} . ln \left[ \frac{-(1-\rho)^2 + \sqrt{(1-\rho)^4 + 4.T^2.\rho^2}}{2.T.\rho^2} \right]$$

where $\rho = (n-1)^2/(n+1)^2$.

In particular, the glass sheet V1 of the invention has a coefficient of absorption at the wavelength $\lambda 2$ lower than 3 $m^{-1}$. Preferably, the glass sheet V1 has a coefficient of absorption at the wavelength $\lambda 2$ lower than 2 $m^{-1}$, or even lower than 1.5 $m^{-1}$ and, even more preferably, lower than 1 $m^{-1}$, or even lower than 0.8 $m^{-1}$.

One way proposed in the invention of obtaining a glass sheet that is very transparent at the wavelength $\lambda 2$ consists in combining, in the composition of the glass, both a low iron and a low chromium content, said contents lying in a specific range of contents.

The glass sheet V1 of the device of the present invention has a composition that comprises, in a content expressed in percentage by total weight of glass:

| | |
|---|---|
| Total iron expressed in the form of $Fe_2O_3$ | 0.002 - 0.06%; |
| $Cr_2O_3$ | 0.0001 - 0.06%. |

Such glass compositions combining a low iron and chromium content have demonstrated a particularly good performance in terms of transmittance in the 800-1400 nm range and exhibit a high transparency in the visible and a not very pronounced tint, close to a what is called "extra-clear" glass. These compositions are described in international patent applications WO2014128016A1, WO2014180679A1, WO2015011040A1, WO2015011041A1, WO2015011042A1, WO2015011043A1 and WO2015011044A1.

According to a first particular embodiment, the composition preferably comprises a chromium (expressed in the form of $Cr_2O_3$) content ranging from 0.002% to 0.06% by weight with respect to the total weight of the glass. Such chromium contents allow the transmittance of the glass sheet in the 800-1400 nm range to be further improved.

According to another embodiment of the invention, the glass sheet V1 has a composition that comprises, in a content expressed in percentage by total weight of glass:

| | |
|---|---|
| Total iron (expressed in the form of $Fe_2O_3$) | 0.002 - 0.06%; |
| $Cr_2O_3$ | 0.0015 - 1% |
| Co | 0.0001 - 1%. |

Such glass compositions based on chromium and cobalt have demonstrated a particularly good performance in terms of transmittance in the 800-1400 nm range, while creating interesting possibilities in terms of aesthetics/colour. These compositions are described in European patent application no. 13 198 454.4.

Alternatively to chromium, other solutions combining, in a glass composition, a low iron content and one or more other components in specific quantities, allow a glass sheet that is very transparent in the 800-1400 nm range to be obtained, with little or no impact on its aesthetics and colour. Such compositions are described in European patent application no. 13 193 345.9.

The glass sheet V1 preferably has a transmittance at the wavelength $\lambda 1$ higher than 20%. Preferably, the glass sheet V1 has a transmittance at the wavelength $\lambda 1$ higher than 30% or, even better still, higher than 40%. More preferably, the glass sheet V1 has a transmittance at the wavelength $\lambda 1$ higher than 50% or even higher than 60%. Most preferably, the glass sheet V1 has a transmittance at the wavelength $\lambda 1$ higher than 70% or even higher than 80%. It will of course be clear that the higher the transmittance of the sheet V1 at $\lambda 1$, the greater the benefit to the overall output of the device of the invention.

Advantageously, the glass sheet V1 preferably has a light transmittance TLA4 higher than 10% or, even better still, higher than 20%. Preferably, the glass sheet V1 has a light transmittance TLA4 higher than 30% or, even better still, higher than 40%. More preferably, the glass sheet V1 has a light transmittance TLA4 higher than 50 or even higher than 60%. Most preferably, the glass sheet V1 has a light transmittance TLA4 higher than 70% or even higher than 80%. This has the advantage of allowing the device according to the invention to be used as a particularly aesthetic glazing unit in the architectural field.

In the device of the invention, the photovoltaic cells according to the invention may be positioned, as illustrated in Figure 1(b), (i) on one or more edge faces of the assembly (C1), and/or (ii) on the major face f1 (C2), and/or (iii) on the major face f3 (C3).

According to one embodiment of the device according to invention, the photovoltaic cells are positioned only on one or more edge faces of the assembly (C1). This is particularly advantageous in order to obtain a device the aesthetics of which are not deteriorated by the sight of the solar cells and that is therefore usable as an architectural glazing unit.

The photovoltaic cells according to the invention may advantageously be the cells known as crystalline-silicon cells or even "CIGS" cells, or any other type of photovoltaic cells sensitive to the wavelengths $\lambda 2$.

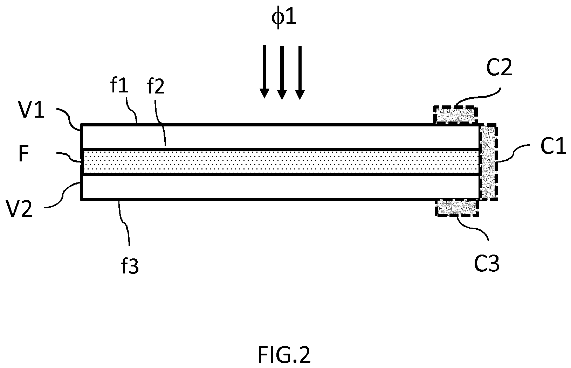

According to one embodiment of the invention illustrated in Figure 2, the device also comprises a glass sheet V2 that covers the functional layer F and that has a coefficient of absorption at the wavelength $\lambda 2$ lower than 3 $m^{-1}$. This makes it possible to make the assembly more solid and durable, the functional layer being completely protected from the exterior environment by the glass, without affecting the good operation of the PV device or its performance.

In the device embodiment illustrated in Figure 2, the photovoltaic cells may be positioned (i) on one or more edge faces of the assembly (C1), and/or (ii) on the external major face f1 (C2), and/or (iii) on the external major face f3 (C3). Preferably, the photovoltaic cells are positioned only on one or more edge faces of the assembly in Figure 2 (C1).

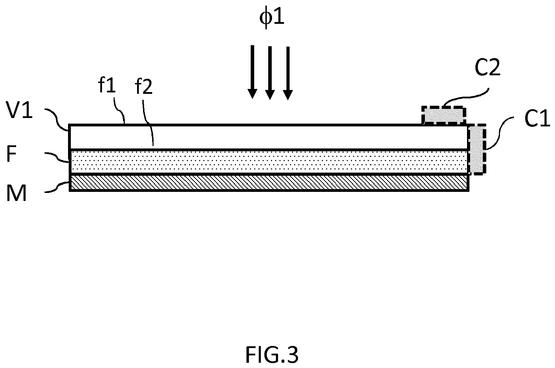

According to one embodiment of the invention, which embodiment is illustrated in Figure 3 and which is a variant of the embodiment in Figure 1, the device comprises a mirror layer M covering said functional layer F and located on an external face.

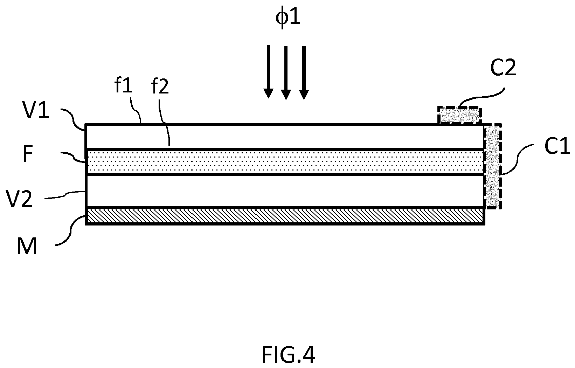

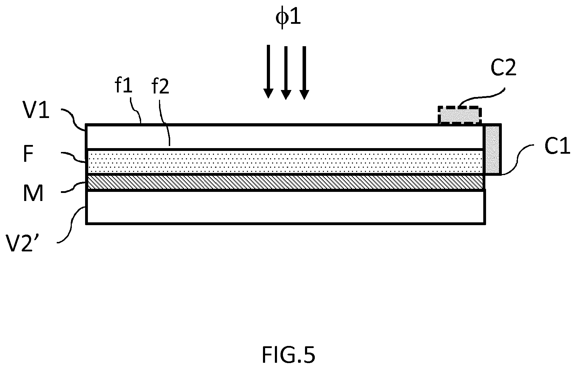

The embodiments of the invention illustrated in Figures 4 and 5 are variants of the embodiments in Figures 2 and 3, respectively.

In figure 4, the device according to the invention comprises:

- a glass sheet V2 that covers the functional layer F and that has a coefficient of absorption at the wavelength $\lambda 2$ lower than 3 $m^{-1}$; and

- a mirror layer M covering said glass sheet V2 and located on an external face.

In Figure 5, which shows a variant of Figure 3, the device according to the invention also comprises:

- a glass sheet V2'; and

- a mirror layer M covering the functional layer F and interposed between said functional layer and the sheet V2'.

The mirror layer M according to the embodiments in Figures 3, 4 and 5 may for example be what is called a "triple silver" (Ag3) layer or any layer that reflects the wavelength $\lambda 2$. Thus, reflection towards the interior of the assembly is increased and the PV output of the device improved thereby.

According to the embodiments in Figures 3, 4 and 5, the photovoltaic cells may be positioned (i) on one or more edge faces of the assembly (C1), and/or (ii) on the external major face f1 (C2). Preferably, the photovoltaic cells are positioned only on one or more edge faces of the assembly in Figure 3, 4 or 5 (C1).

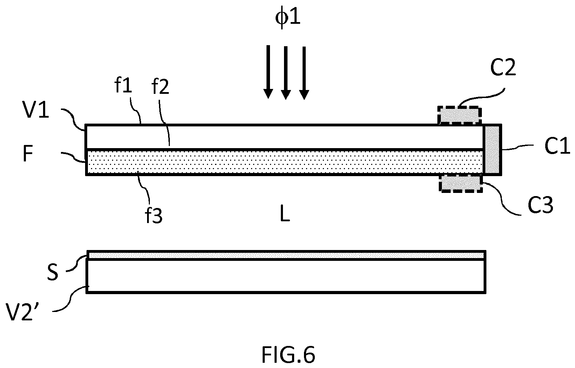

According to another embodiment of the invention illustrated in Figure 6, the device according to the invention forms an insulating multiple glazing unit and comprises:

- at least one glass sheet V2' spaced apart from the functional layer F by a gas-filled cavity L (for example filled with air); and

- a layer S covering said glass sheet V2' and located inside the insulating multiple glazing unit on the side of the cavity L, said layer being a solar-control or low-emissivity ("low-e") layer.

In the device embodiment illustrated in Figure 6, the photovoltaic cells may be positioned (i) on one or more edge faces of the assembly (C1), and/or (ii) on the external major face f1 (C2), and/or (iii) on the face f3 (C3). Preferably, the photovoltaic cells are positioned only on one or more edge faces of the assembly in Figure 6 (C1).

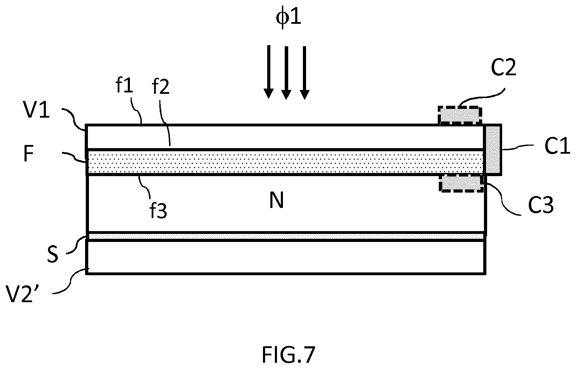

According to another embodiment of the invention illustrated in Figure 7, the device according to the invention furthermore comprises:

- a low-refractive-index layer N covering the functional layer F;

- a solar-control or low-emissivity ("low-e") layer S covering the low-refractive-index layer N; and

- a glass sheet V2' covering the layer S.

In the device embodiment illustrated in Figure 7, the photovoltaic cells may be positioned (i) on one or more edge faces of the assembly (C1), and/or (ii) on the external major face f1 (C2), and/or (iii) on the face f3, the cells then being encapsulated in the material of the layer N (C3). Preferably, the photovoltaic cells are positioned only on one or more edge faces of the assembly in Figure 7 (C1).

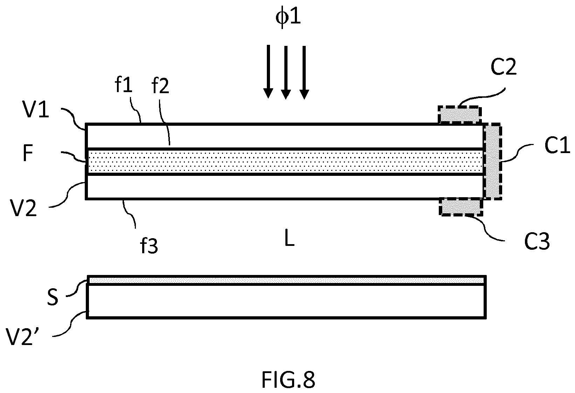

The embodiment of the invention illustrated in Figure 8 is a variant of the embodiment in Figure 2. According to this variant, the device forms an insulating multiple glazing unit and furthermore comprises:

- a glass sheet V2 that covers the functional layer F and that has a coefficient of absorption at the wavelength $\lambda$2 lower than 3 $m^{-1}$;

- at least one glass sheet V2' spaced apart from the functional layer F by a gas-filled cavity L (for example filled with air); and

- a layer S covering said glass sheet V2' and located inside the insulating multiple glazing unit on the side of the cavity L; said layer being a solar-control or low-emissivity ("low-e") layer.

In the embodiments in Figures 2, 4 and 8 comprising a glass sheet V2, the glass sheet V2 preferably has a coefficient of absorption at the wavelength $\lambda$2 lower than 2 $m^{-1}$, or even lower than 1.5 $m^{-1}$ and, even more preferably, lower than 1 $m^{-1}$, or even lower than 0.8 $m^{-1}$. In addition, the glass sheet V2 preferably has a light transmittance TLA4 higher than 10% or, even better still, higher than 20%. Preferably, the glass sheet V2 has a light transmittance TLA4 higher than 30% or, even better still, higher than 40%. More preferably, the glass sheet V2 has a light transmittance TLA4 higher than 50 or even higher than 60%. Most preferably, the glass sheet V2 has a light transmittance TLA4 higher than 70% or even higher than 80%. This has the advantage of allowing the device according to the invention to be used as a particularly aesthetic glazing unit in the architectural field. The glass sheet V2 may be a glass sheet obtained by a float process, a drawing process, or a rolling process or any other known process for manufacturing a glass sheet from a molten glass composition. Preferably, the glass sheet V2 is a float glass sheet. The glass sheet V2 may have a thickness varying between 0.1 and 25 mm. Advantageously the glass sheet V2 according to the invention may have a thickness between 4 and 12 mm. The glass sheet V2 is made of glass possibly belonging to various categories in terms of base composition. The glass can thus be a glass of soda-lime-silica, aluminosilicate or borosilicate type, and the like. Preferably, the base composition of the glass sheet V2 comprises, in a content expressed in percentage by total weight of glass:

| | |
|---|---|
| $SiO_2$ | 55 - 85% |
| $Al_2O_3$ | 0 - 30% |
| $B_2O_3$ | 0 - 20% |
| $Na_2O$ | 0 - 25% |
| CaO | 0 - 20% |
| MgO | 0 - 15% |
| $K_2O$ | 0 - 20% |
| BaO | 0 - 20%. |

More preferably, the base composition of the glass sheet V2 comprises, in a content expressed in percentage by total weight of glass:

| | |
|---|---|
| $SiO_2$ | 55 - 78% |
| $Al_2O_3$ | 0 - 18% |
| $B_2O_3$ | 0 - 18% |

(continued)

| | |
|---|---|
| Na$_2$O | 0 - 20% |
| CaO | 0 - 15% |
| MgO | 0 - 10% |
| K$_2$O | 0 - 10% |
| BaO | 0 - 5%. |

Most preferably, the glass sheet V2 according to the invention is a sheet of soda-lime-silica glass. Advantageously, according to this embodiment, the base composition of the glass sheet V2 comprises, in a content expressed in percentage by total weight of glass:

| | |
|---|---|
| SiO$_2$ | 60 - 75% |
| Al$_2$O$_3$ | 0 - 6% |
| B$_2$O$_3$ | 0 - 4% |
| CaO | 0 - 15% |
| MgO | 0 - 10% |
| Na$_2$O | 5 - 20% |
| K$_2$O | 0 - 10% |
| BaO | 0 - 5%. |

In addition to its base composition, the glass sheet V2 may comprise other components, of nature and quantity tailored to the sought-after effect.
In addition, the glass sheet V2 may advantageously have a composition that comprises, in an amount expressed as a percentage of the total weight of glass:

| | |
|---|---|
| Total iron (expressed in the form of Fe$_2$O$_3$) | 0.002 - 0.06%; |
| Cr$_2$O$_3$ | 0.0001 - 0.06%. |

According to this particular embodiment, the composition of the glass sheet V2 preferably comprises a chromium (expressed in the form of Cr$_2$O$_3$) content ranging from 0.002% to 0.06% by weight with respect to the total weight of the glass.
The glass sheet V2 may also have a composition that comprises, in an amount expressed as a percentage of the total weight of glass:

| | |
|---|---|
| Total iron (expressed in the form of Fe$_2$O$_3$) | 0.002 - 0.06%; |
| Cr$_2$O$_3$ | 0.0015 - 1% |
| Co | 0.0001- 1%. |

Alternatively to chromium, other compositions suitable for the glass sheet V2 are described in European patent application no. 13 193 345.9.
In the embodiments of Figures 2, 4 and 8, the glass sheets V1 and V2 may have substantially the same composition or, alternatively, they may be of different compositions.
In the embodiments in Figures 5, 6, 7 and 8, the glass sheet V2' may be a glass sheet obtained by a float process, a drawing process, or a rolling process or any other known process for manufacturing a glass sheet from a molten glass composition. Preferably, the glass sheet V2' is a float glass sheet. The glass sheet V2' may have a thickness varying between 0.1 and 25 mm. Advantageously the glass sheet V'2 according to the invention may have a thickness between 4 and 12 mm. The glass sheet V2' is made of glass possibly belonging to various categories in terms of base composition. The glass may thus be a soda-lime-silica glass, an aluminosilicate glass, a borosilicate glass, etc.
The functional layer F according to the invention covers the second major face f2 of the sheet V1 and comprises a matrix in which are dispersed the luminescent elements. By "dispersed", what is meant according to the invention is that the luminescent elements are dissolved and/or in suspension in particle form in the matrix.
The matrix of the invention may be made of any type of material capable of allowing the luminescent elements to be dispersed and of allowing adhesion thereof to a glass sheet, and even lamination thereof. It may be a question, for example, of a plastic, such as a sheet of PVB, of PU, of ionomer or of EVA. It may also be a layer of transparent lacquer (clearcoat), such as for example a layer of epoxy resin or methacrylate.

Advantageously, the functional layer F according to the invention has a coefficient of absorption at the wavelength $\lambda 2$ lower than 5 m$^{-1}$ and preferably lower than 3 m$^{-1}$. More preferably, the functional layer F according to the invention has a coefficient of absorption at the wavelength $\lambda 2$ lower than 2 m$^{-1}$, or even lower than 1.5 m$^{-1}$ and, even more preferably, lower than 1 m$^{-1}$, or even lower than 0.8 m$^{-1}$.

Advantageously, the functional layer F according to the invention has a refractive index higher than 1.3; 1.4; 1.5 or even 1.6 or 1.7; or indeed higher than 2. This has the advantage of limiting the proportion of the re-emitted radiation that escapes from the glass directly without being propagated by total internal reflection therein

Advantageously, the functional layer F preferably has a light transmittance TLA4 higher than 10% or, even better still, higher than 20%. Preferably, the functional layer F has a light transmittance TLA4 higher than 30% or, even better still, higher than 40%. More preferably, the functional layer F has a light transmittance TLA4 higher than 50 or even higher than 60%. Most preferably, the functional layer F has a light transmittance TLA4 higher than 70% or even higher than 80%. This has the advantage of allowing the device according to the invention to be used as a particularly aesthetic glazing unit in the architectural field.

The luminescent elements according to the invention are capable of absorbing the incident radiation $\Phi 1$ of wavelength $\lambda 1$ and of re-emitting it with a wavelength $\lambda 2$ longer than $\lambda 1$ and comprised between 800 and 1400 nm.

The luminescent elements according to the invention may be of organic and/or inorganic nature but are preferably of inorganic nature for reasons of stability over time. The luminescent elements according to the invention may (i) take the form of particles dispersed and in suspension in said matrix and/or (ii) be dissolved in the material of the matrix. When the luminescent elements take the form of particles, the size of said particles will ideally be chosen so as to prevent them having too great an impact on the aesthetics and transparency of the assembly according to the invention. The concentration of the luminescent elements in the matrix is ideally chosen in order to achieve a balance between the impact on the aesthetics/transparency of the assembly and the PV performance of the device, while taking into account the compatibility of the luminescent elements and the material of the matrix. By way of example, concentrations of about 0.01% by weight to 0.5 or even 1% by weight are often quite enough.

Examples of luminescent elements (LE) usable in the invention are given in the following table, which also mentions the corresponding wavelengths $\lambda 1$ and $\lambda 2$.

The functional layer according to the invention may comprise a mixture of different luminescent elements.

According to one advantageous embodiment of the invention, the wavelength $\lambda 1$ is comprised between 280 and 380 nm. By choosing a $\lambda 1$ outside of the visible and in particular in the UV, it is possible to prevent the device from appearing to have a colour, this often being undesirable in architectural applications.

**Table 1**

| LE | $\lambda 1$ (nm) | $\lambda 2$ (nm) |
|---|---|---|
| Yttrium oxide doped with one or more rare-earths and sensitized ytterbium, Y2O3:RE,Yb | ~ 980 | ~ 1000 |
| Neodymium-doped yttrium phosphate, YPO4:Nd | 940-980 | ~ 1060 |
| Copper-doped zinc cadmium sulphide, (Zn,Cd)S:Cu | 300-550 | ~ 940 |

According to one advantageous embodiment of the invention, the wavelength $\lambda 1$ is comprised between 750 and 950 nm. By choosing a $\lambda 1$ outside of the visible and in particular in the near infrared, it is possible to prevent the device from appearing to have a colour, this often being undesirable in architectural applications.

Ideally, the difference between the two wavelengths and $\lambda 2$ is large enough to prevent energy-loss effects due to reabsorption of the radiation $\phi 2$ and, in particular, preferably, $(\lambda 2 - \lambda 1) \geq 20$ nm, and even better still, $(\lambda 2 - \lambda 1) \geq 50$ nm.

Advantageously, when is located in the near infrared, the wavelength $\lambda 2$ is longer than 900 nm if it is desired to prevent $\lambda 1$ and $\lambda 2$ from being too close together and thus to prevent reabsorption. Also advantageously, the wavelength $\lambda 2$ is shorter than 1200 nm because the conventional commercially available solar cells (crystalline Si and CIGS cells) are insensitive beyond this wavelength. Very advantageously, the wavelength $\lambda 2$ is comprised between 900 and 1200 nm.

The embodiment combining a wavelength $\lambda 1$ comprised between 280 and 380 nm and a wavelength $\lambda 2$ comprised between 900 and 1200 nm is advantageous.

The embodiment combining a wavelength $\lambda 1$ between 280 and 380 nm, with a wavelength $\lambda 2$ comprised between 900 and 1200 nm and $(\lambda 2 - \lambda 1) \geq 50$ nm is especially advantageous. We will thus mention (Zn,Cd)S:Cu as being a particularly suitable choice by way of electroluminescent element in the present invention.

The embodiment combining a wavelength $\lambda 1$ between 750 and 950 nm, with a wavelength $\lambda 2$ comprised between 900 and 1200 nm and $(\lambda 2 - \lambda 1) \geq 50$ nm is also especially advantageous.

The present invention of course also covers the case where the incident radiation is composed of a plurality of

constituents $\phi1$, $\phi1'$, $\phi1''$,... of wavelengths $\lambda1$, $\lambda1'$, $\lambda1''$,... comprised between 280 and 1000 nm, which wavelengths are converted by luminescent elements into wavelengths $\lambda2$, $\lambda2'$, $\lambda2''$,... comprised between 800 and 1400 nm; the device then comprising at least one photovoltaic cell sensitive to $\lambda2$, at least one photovoltaic cell sensitive to $\lambda2'$, at least one photovoltaic cell sensitive to $\lambda2''$, etc. ; it being understood that said photovoltaic cells may or may not be specific to a single wavelength from $\lambda2$, $\lambda2'$, $\lambda2''$,... (one cell possibly being sensitive to a plurality of wavelengths among $\lambda2$, $\lambda2'$, $\lambda2''$,...).

Advantageously, according to one embodiment, the device of the invention has an overall light transmittance higher than 10%, and preferably higher than 20%, or even better still higher than 30%,or even higher than 40%. More preferably, the device has an overall light transmittance higher than 50%, 60% or 70%, and most preferably higher than 80%. This has the advantage of allowing the device according to the invention to be used as a particularly aesthetic glazing unit in the architectural field.

Advantageously, the glass sheet V1 may be covered externally with an antireflection treatment or layer (on face f1) thus allowing a maximum of incident radiation to penetrate into the photovoltaic device.

Depending on the desired properties and/or applications other layers/other treatments may be deposited/carried out on one and/or other face of the glass sheet(s) of the device of the invention. For example, in the case of an architectural application requiring a high level of solar protection, the device of the invention may be combined with a semitransparent photovoltaic film. This has the advantage of combining the output of the device of the invention and the output of the photovoltaic film while providing an adequate level of solar protection without using absorbent glass.

## Claims

1.  Photovoltaic device intended to convert into electricity incident radiation $\phi1$ of a wavelength $\lambda1$ comprised between 280 and 1000 nm, comprising:

    - an assembly having two external major faces f1 and f3, comprising

        a. a glass sheet V1 having two major faces f1 and f2, the face f1 being that via which the incident radiation penetrates into said assembly and said sheet V1 being transparent to said incident radiation $\phi1$;
        b. a functional layer F covering the major face f2 of the sheet V1 and comprising a matrix in which are dispersed luminescent elements capable of absorbing said incident radiation $\phi1$ of wavelength $\lambda1$ and of re-emitting it with a wavelength $\lambda2$ longer than $\lambda1$ and comprised between 800 and 1400 nm;

        which assembly plays the role of waveguide for the radiation re-emitted of wavelength $\lambda2$, and
        - at least one photovoltaic cell (C1, C2, C3, ...) positioned (i) on one or more edge faces of the assembly, and/or (ii) on the major face f1, and/or (iii) on the major face f3, and at which the re-emitted radiation of wavelength $\lambda2$ arrives and which is sensitive to the wavelength $\lambda2$;

    in which device, the glass sheet V1 has a coefficient of absorption at the wavelength $\lambda2$ lower than 3 m$^{-1}$ and has a composition that comprises, in a content expressed in percentage by total weight of glass:

    | | |
    |---|---|
    | Total iron expressed in the form of $Fe_2O_3$ | 0.002 - 0.06%; |
    | $Cr_2O_3$ | 0.0001 - 0.06%. |

2.  Photovoltaic device according to Claim 1, **characterized in that** the wavelength $\lambda1$ is comprised between 280 and 380 nm.

3.  Photovoltaic device according to Claim 1, **characterized in that** the wavelength $\lambda1$ is comprised between 750 and 950 nm.

4.  Photovoltaic device according to one of the preceding claims, **characterized in that**: $(\lambda2 - \lambda1) \geq 20$ nm.

5.  Photovoltaic device according to the preceding claim, **characterized in that**: $(\lambda2 - \lambda1) \geq 50$ nm.

6.  Photovoltaic device according to one of the preceding claims, **characterized in that** said photovoltaic cells are positioned only on one or more edge faces of the assembly.

7. Photovoltaic device according to one of the preceding claims, **characterized in that** the glass sheet V1 has a coefficient of absorption at the wavelength $\lambda 2$ lower than 2 m$^{-1}$.

8. Photovoltaic device according to the preceding claim, **characterized in that** the glass sheet V1 has a coefficient of absorption at the wavelength $\lambda 2$ lower than 1.5 m$^{-1}$.

9. Photovoltaic device according to the preceding claim, **characterized in that** the glass sheet V1 has a coefficient of absorption at the wavelength $\lambda 2$ lower than 1 m$^{-1}$.

10. Photovoltaic device according to one of the preceding claims, **characterized in that** the functional layer F has a coefficient of absorption at the wavelength $\lambda 2$ lower than 5 m$^{-1}$.


**Patentansprüche**

1. Photovoltaikvorrichtung, die dafür vorgesehen ist, eine einfallende Strahlung $\Phi 1$ mit einer Wellenlänge $\lambda 1$, die im Bereich von 280 bis 1000 nm liegt, in Elektrizität umzuwandeln, die Folgendes umfasst:

   - eine Baugruppe mit zwei Hauptaußenflächen f1 und f3, die Folgendes umfasst:

     a. eine Glasplatte V1 mit zwei Hauptflächen f1 und f2, wobei die Fläche f1 jene ist, über die die einfallende Strahlung in die Baugruppe eindringt, und die Platte V1 für die einfallende Strahlung $\Phi 1$ durchsichtig ist;
     b. eine funktionale Schicht F, die die Hauptfläche f2 der Platte V1 abdeckt und eine Matrix umfasst, in der lumineszierende Elemente fein verteilt sind, die die einfallende Strahlung $\Phi 1$ mit der Wellenlänge $\lambda 1$ absorbieren und sie mit einer Wellenlänge $\lambda 2$, die länger als ist und im Bereich von 800 bis 1400 nm liegt, erneut emittieren können;

     wobei die Baugruppe die Rolle eines Wellenleiters für die erneut emittierte Strahlung mit der Wellenlänge $\lambda 2$ spielt,
     und
     - mindestens eine Photovoltaikzelle (C1, C2, C3, ...), die (i) auf einer oder mehreren Kantenflächen der Baugruppe und/oder (ii) auf der Hauptfläche f1 und/oder (iii) auf der Hauptfläche f3 angeordnet ist und bei der die erneut emittierte Strahlung mit der Wellenlänge $\lambda 2$ eintrifft und die für die Wellenlänge $\lambda 2$ empfindlich ist;

   wobei die Glasplatte V1 in der Vorrichtung einen Absorptionskoeffizienten für die Wellenlänge $\lambda 2$ aufweist, der kleiner als 3 m$^{-1}$ ist, und eine Zusammensetzung aufweist, die in einem Gehalt, der als Prozentsatz des Glasgesamtgewichts ausgedrückt ist, Folgendes umfasst: Gesamtgehalt Eisen, ausgedrückt durch $Fe_2O_3$: 0,002-0,06 % $Cr_2O_3$: 0, 0001-0, 06 %.

2. Photovoltaikvorrichtung nach Anspruch 1, **dadurch gekennzeichnet, dass** die Wellenlänge $\lambda 1$ im Bereich von 280 bis 380 nm liegt.

3. Photovoltaikvorrichtung nach Anspruch 1, **dadurch gekennzeichnet, dass** die Wellenlänge $\lambda 1$ im Bereich von 750 bis 950 nm liegt.

4. Photovoltaikvorrichtung nach einem der vorhergehenden Ansprüche, **dadurch gekennzeichnet, dass**: $(\lambda 2 - \lambda 1) \geq$ 20 nm.

5. Photovoltaikvorrichtung nach dem vorhergehenden Anspruch, **dadurch gekennzeichnet, dass**: $(\lambda 2 - \lambda 1) \geq$ 50 nm.

6. Photovoltaikvorrichtung nach einem der vorhergehenden Ansprüche, **dadurch gekennzeichnet, dass** die Photovoltaikzellen lediglich auf einer oder mehreren Kantenflächen der Baugruppe angeordnet sind.

7. Photovoltaikvorrichtung nach einem der vorhergehenden Ansprüche, **dadurch gekennzeichnet, dass** die Glasplatte V1 einen Absorptionskoeffizienten für die Wellenlänge $\lambda 2$ aufweist, der kleiner als 2 m$^{-1}$ ist.

8. Photovoltaikvorrichtung nach dem vorhergehenden Anspruch, **dadurch gekennzeichnet, dass** die Glasplatte V1 einen Absorptionskoeffizienten für die Wellenlänge $\lambda 2$ aufweist, der kleiner als 1,5 m$^{-1}$ ist.

**9.** Photovoltaikvorrichtung nach dem vorhergehenden Anspruch, **dadurch gekennzeichnet, dass** die Glasplatte V1 einen Absorptionskoeffizienten für die Wellenlänge $\lambda 2$ aufweist, der kleiner als 1 m$^{-1}$ ist.

**10.** Photovoltaikvorrichtung nach einem der vorhergehenden Ansprüche, **dadurch gekennzeichnet, dass** die funktionale Schicht F einen Absorptionskoeffizienten für die Wellenlänge $\lambda 2$ aufweist, der kleiner als 5 m$^{-1}$ ist.

**Revendications**

**1.** Dispositif photovoltaïque destiné à convertir en électricité un rayonnement incident $\phi 1$ d'une longueur d'onde comprise entre 280 et 1000 nm, comprenant :

- un ensemble ayant deux faces externes principales f1 et f3, comprenant

a. une feuille de verre V1 ayant deux faces principales f1 et f2, la face f1 étant celle par laquelle le rayonnement incident pénètre dans ledit ensemble et ladite feuille V1 étant transparente audit rayonnement incident $\phi 1$ ;
b. une couche fonctionnelle F recouvrant la face principale f2 de la feuille V1 et comprenant une matrice dans laquelle sont dispersés des éléments luminescents pouvant absorber ledit rayonnement incident $\phi 1$ de longueur d'onde et le réémettre avec une longueur d'onde $\lambda 2$ plus longue que et comprise entre 800 et 1400 nm ;

lequel ensemble joue le rôle de guide d'ondes pour le rayonnement réémis de longueur d'onde $\lambda 2$, et
- au moins une cellule photovoltaïque (C1, C2, C3, ...) positionnée (i) sur une ou plusieurs faces latérales de l'ensemble, et/ou (ii) sur la face principale f1, et/ou (iii) sur la face principale f3, et au niveau de laquelle le rayonnement réémis de longueur d'onde $\lambda 2$ arrive et qui est sensible à la longueur d'onde $\lambda 2$ ; dispositif dans lequel la feuille de verre V1 a un coefficient d'absorption à la longueur d'onde $\lambda 2$ inférieur à 3 m$^{-1}$ et a une composition qui comprend, en contenu exprimé en pourcentage en poids total de verre : Fer total exprimé sous la forme de $Fe_2O_3$ 0,002-0,06 % ; $Cr_2O_3$ 0, 0001-0, 06 %.

**2.** Dispositif photovoltaïque selon la revendication 1, **caractérisé en ce que** la longueur d'onde est comprise entre 280 et 380 nm.

**3.** Dispositif photovoltaïque selon la revendication 1, **caractérisé en ce que** la longueur d'onde est comprise entre 750 et 950 nm.

**4.** Dispositif photovoltaïque selon une des revendications précédentes, **caractérisé en ce que** : $(\lambda 2 - \lambda 1) \geq 20$ nm.

**5.** Dispositif photovoltaïque selon la revendication précédente, **caractérisé en ce que** : $(\lambda 2 - \lambda 1) \geq 50$ nm.

**6.** Dispositif photovoltaïque selon une des revendications précédentes, **caractérisé en ce que** lesdites cellules photovoltaïques sont positionnées uniquement sur une ou plusieurs faces latérales de l'ensemble.

**7.** Dispositif photovoltaïque selon une des revendications précédentes, **caractérisé en ce que** la feuille de verre V1 a un coefficient d'absorption à la longueur d'onde $\lambda 2$ inférieur à 2 m$^{-1}$.

**8.** Dispositif photovoltaïque selon la revendication précédente, **caractérisé en ce que** la feuille de verre V1 a un coefficient d'absorption à la longueur d'onde $\lambda 2$ inférieur à 1,5 m$^{-1}$.

**9.** Dispositif photovoltaïque selon la revendication précédente, **caractérisé en ce que** la feuille de verre V1 a un coefficient d'absorption à la longueur d'onde $\lambda 2$ inférieur à 1 m$^{-1}$.

**10.** Dispositif photovoltaïque selon une des revendications précédentes, **caractérisé en ce que** la couche fonctionnelle F a un coefficient d'absorption à la longueur d'onde $\lambda 2$ inférieur à 5 m$^{-1}$.

(a)

(b)

FIG.1

FIG.2

FIG.3

FIG.4

FIG.5

FIG.6

FIG.7

FIG.8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0004242 B1
- DE 2628291
- US 4127425 A
- EP 0004242 B
- US 4727425 A
- US 20130087193 A
- US 2010139769 A
- WO 2014128016 A1
- WO 2014180679 A1
- WO 2015011040 A1
- WO 2015011041 A1
- WO 2015011042 A1
- WO 2015011043 A1
- WO 2015011044 A1
- EP 13198454 A
- EP 13193345 A

**Non-patent literature cited in the description**

- **E. WEBER ; J. LAMBE.** *Applied Optics,* vol. 15 (10), 2299-2300